# EUROPÄISCHE PATENTSCHRIFT

(11) **EP 3 152 989 B1**
(45) Veröffentlichungstag und Bekanntmachung des Hinweises auf die Patenterteilung: **14.03.2018**
(21) Anmeldenummer: 15742176.9
(22) Anmeldetag: 05.06.2015
(51) Int. Cl.: H05K 7/20

(54) **KÜHLGERÄT, INSBESONDERE FÜR DIE KÜHLUNG VON IN EINEM SCHALTSCHRANK AUFGENOMMENEN KOMPONENTEN, SOWIE EINE ENTSPRECHENDE VERWENDUNG UND EIN ENTSPRECHENDES VERFAHREN**
COOLING DEVICE, IN PARTICULAR FOR COOLING COMPONENTS HOUSED IN A SWITCHGEAR CABINET, CORRESPONDING USE AND CORRESPONDING METHOD
APPAREIL FRIGORIFIQUE, DESTINÉ EN PARTICULIER À REFROIDIR DES COMPOSANTS LOGÉS DANS UNE ARMOIRE ÉLECTRIQUE, UTILISATION CORRESPONDANTE ET PROCÉDÉ CORRESPONDANT

(30) Priorität: 05.06.2014 DE 102014107931
(43) Veröffentlichungstag der Anmeldung: 12.04.2017
(73) Patentinhaber: Rittal GmbH & Co. KG, 35745 Herborn (DE)
(72) Erfinder: ROSENTHAL, Daniel, 57072 Siegen (DE); CACHO ALONSO, Juan Carlos, 38102 Braunschweig (DE); HEIMBERG, Thorsten, 35641 Schöffengrund (DE); KNETSCH, Jörg, 35630 Ehringshausen (DE)
(74) Vertreter: Angerhausen, Christoph
(86) Internationale Anmeldenummer: PCT/DE2015/100226
(87) Internationale Veröffentlichungsnummer: WO 2015/185040

(56) Entgegenhaltungen:
- JP-A- H01 197 110
- US-A1- 2004 007 347
- US-B1- 6 345 512

## Beschreibung

Die Erfindung betrifft ein Kühlgerät, insbesondere für die Kühlung von in einem Schaltschrank aufgenommenen Komponenten, sowie eine entsprechende Verwendung und ein entsprechendes Verfahren.

Ein gattungsgemäßes Kühlgerät weist einen ersten Lüfter für die Durchströmung eines ersten Wärmetauschers mit Schaltschrankluft und einen zweiten Lüfter für die Durchströmung eines zweiten Wärmetauschers mit Umgebungsluft auf, wobei das Kühlgerät weiterhin einen verdichtergetriebenen Kühlkreislauft mit einem Verdichter und einem elektronischen Drosselorgan aufweist. Ein derartiges Kühlgerät ist aus der US 6,345,512 B1 bekannt. Ein ähnliches Kühlgerät für ein Fahrzeug beschreibt die JP H01 197110 A.

Aus dem Stand der Technik sind derartige Kühlgeräte bekannt, bei denen die elektrischen Komponenten hinsichtlich der für den Betrieb erforderlichen Spannungsversorgung auf die im vorgesehenen geografischen Einsatzgebiet des Kühlgeräts vorherrschenden elektrischen Netzspannungen angepasst sind. So ist es beispielsweise üblich, dass für jede Leistungsstufe eines Kühlgeräts jeweils eine Variante für eine Netzspannung von 115 V, 230 V und für 400 V angeboten wird, um das Kühlgerät weitestgehend weltweit anbieten zu können. Hinzu kommen diverse Sonderspannungen.

Aus dem Stand der Technik sind daher Kühlgeräte bekannt, bei denen je nach erwarteter Netzspannung beispielsweise ein entsprechender Transformator mit einem Primäreingang von 115 V, 200, 230 V, 400 V oder 460 V verwendet wird, wobei dieser dann je nach Primäreingangsspannung etwa eine Sekundärausgangsspannung von 230 V, 400 V oder 460 V bei diversen Leistungen bereitstellt. Je nach Sekundärausgangsspannung des Transformators weist das Kühlgerät einen Controller auf, der bei der jeweiligen Sekundärausgangsspannung des Transformators betrieben wird und mit entsprechenden Spannungen die regelbaren elektrischen Bauteile des Kühlgeräts, insbesondere die Lüfter, und, falls vorhanden, einen Verdichter, die Sensorik oder ein Expansionsventil ansteuert. Dies erfordert wiederum, dass auch diese von dem Controller angesteuerten Kühlgerätekomponenten, je nach vorgesehenem geographischen Anwendungsgebiet des Kühlgeräts und der dort vorherrschenden Netzspannung in einer darin angepassten Spannungsvariante von 150 V, 200 V, 230 V, 400 V oder 460 V bereitgestellt werden. Bei noch anderen Kühlgeräten aus dem Stand der Technik werden die aktiven Kühlgerätekomponenten auch über einen Transformator mit einer angepassten Spannung betrieben.

Es ist daher die Aufgabe der Erfindung, ein gattungsgemäßes Kühlgerät vorzuschlagen, bei dem eine einzige Bauform ausreichend ist, um es bei unterschiedlichen Eingangswechselspannungen betreiben zu können.

Diese Aufgabe wird erfindungsgemäß durch ein Kühlgerät mit den Merkmalen des Patentanspruchs 1 gelöst. Die abhängigen Ansprüche 2 bis 7 betreffen vorteilhafte Ausführungsformen. Der Anspruch 9 betrifft die Verwendung eines erfindungsgemäßen Kühlgeräts. Die Ansprüche 10 und 11 betreffen ein entsprechendes Verfahren für den Betrieb eines derartigen Kühlgeräts.

Das erfindungsgemäße Kühlgerät zeichnet sich dadurch aus, dass es weiterhin eine Spannungsversorgung mit einem Aufwärts- und/oder einem Abwärtswandler aufweist, der über einen Gleichrichter mit einem Weitbereichseingang für ein- oder mehrphasige Wechselspannung verbunden ist und einen Kondensator auf eine Zwischenkreisspannung auflädt, die oberhalb bzw. unterhalb einer an den Weitbereichseingang anliegenden Netzspannung liegt, wobei der Kondensator parallel zu einem Drehstromwechselrichter geschaltet ist, der einen Drehstrom für den Verdichter bereitstellt, und wobei ein Netzteil mindestens eines der beiden Lüfter parallel zu dem Kondensator geschaltet ist, so dass unabhängig von einer an dem Weitbereichseingang anliegenden ein- oder mehrphasigen Eingangswechselspannung der Verdichter mit einer für eine geforderte Verdichterleistung benötigten Nenndrehspannung betrieben werden kann.

Bei einer einfachsten Ausführungsform ist das Drosselorgan ein Expansionsventil auf. Das Kühlgerät kann einen Drehstromwechselrichter aufweisen, der parallel zu dem Kondensator geschaltet ist und einen Drehstrom für den Verdichter bereitstellt. Das Gerät kann auch ein Rückkühlgerät, beispielsweise ein sogenannter Chiller sein.

Besonders bevorzugt kann die Spannungsversorgung für das Kondensatmanagement des Kühlgeräts einen Heizelementanschluss für ein über einen Controller angesteuertes, elektrisches Heizelement aufweisen, wobei der Anschluss parallel zu dem Kondensator geschaltet ist. Auch ein solches Heizelement kann somit bei dem erfindungsgemäßen Kühlgerät somit als Einspannungsgerät ausgebildet sein und bedarf damit selbst nicht einer Mehrspannungsfähigkeit.

Der Erfindung liegt somit die Idee zugrunde, aktive Bauteile des Kühlgeräts, insbesondere die Lüfter, als Gleichstromgeräte auszubilden und beliebige Eingangswechselspannungen (ein-oder dreiphasig, 100 V - 460 V, 50 Hz oder 60 Hz) in eine jeweilige Gleichspannung für den Betrieb dieser aktiven Kühlgerätekomponenten umzurichten. Ein eventuell für einen Verdichter oder dergleichen benötigter Drehstrom wird von einem Drehstromwechselrichter bereitgestellt und aus der Zeischenkreisgleichspannung gewandelt. Bei dem erfindungsgemäßen Kühlgerät ist es daher nicht mehr notwendig, mehrere Bauformen bereitzustellen, bei denen die Betriebsspannungen der aktiven Komponenten des Kühlgeräts an die Netzspannung oder einer aus dieser transformierbare Spannung angepasst ist.

Bei einer Ausführungsform der Erfindung weist das Kühlgerät zur Erhöhung der Störfestigkeit und zur Verminderung von Störaussendungen einen Netzfilter auf, der mit mindestens einem Außenleiter, einem Schutzleiter und ggf. einem Neutralleiter des Weitbereichseingangs verbunden ist, wobei der Schutzleiter von dem Weitbereichseingang durch den Netzfilter und unmittelbar von dort zu einem Drehstromausgang, an dem der Drehstrom für den Verdichter bereitgestellt ist, geführt ist.

Zur Kühlleistungsvariation eines verdichterbetriebenen Kühlgeräts, ist bei einer Ausführungsform der Erfindung vorgesehen, dass der Drehstromwechselrichter von einem Invertercontroller derart angesteuert ist, dass von dem Drehstromwechselrichter der Drehstrom mit einer Drehstromleistung bereit gestellt ist, die für die Erzielung einer bestimmten Verdichterleistung erforderlich ist.

Bei einer noch anderen Ausführungsform ist der Aufwärts- und/oder Abwärtswandler derart über einen Wandler-Controller angesteuert, dass der Kondensator über den Aufwärts-und/oder Abwärtswandler auf eine Zwischenkreisspannung aufgeladen wird, die derart bemessen ist, dass über das Netzteil eine Netzteilspannung für den Betrieb des ersten oder zweiten Lüfters bereitgestellt ist.

Vorzugsweise ist der Weitbereichseingang für ein- oder dreiphasige Wechselspannung mindestens für Eingangsspannungen zwischen 110 V und 240 V und/oder 380 und 460 V ausgelegt.

Bei noch einer anderen Ausführungsform weisen der Verdichter und/oder die Lüfter BLDC-Motoren auf.

Gemäß einem anderen Aspekt betrifft die Erfindung die Verwendung eines Kühlgeräts der zuvor beschriebenen Art, um unabhängig von einer an dem Weitbereichseingang anliegenden ein- oder mehrphasigen Eingangswechselspannung den Kondensator über den Aufwärtswandler auf eine Zwischenkreisspannung aufzuladen, die derart bemessen ist, dass über das Netzteil eine Netzteilspannung bereitgestellt ist, die für die Erzielung einer bestimmten Lüfterleistung des ersten und/oder zweiten Lüfters erforderlich ist.

Um bei einem Kühlgerät mit verdichtergetriebenen Kühlkreislauf unabhängig von einer an dem Weitbereichseingang anliegenden ein- oder mehrphasigen Eingangswechselspannung den Verdichter mit einer für eine geforderte Verdichterleistung benötigten Nenndrehspannung zu betreiben, ist gemäß einem anderen Aspekt der Erfindung die Verwendung eines Kühlgeräts der zuvor beschriebenen Art derart vorgesehen, dass zur Leistungsvariation des Verdichters der Drehstromwechselrichter darauf ausgelegt ist, die Nenndrehspannung in Abhängigkeit einer geforderten Verdichterleistung anzuheben oder abzusenken.

Gemäß einem noch anderen Aspekt betrifft die Erfindung ein Verfahren für den Betrieb eines Kühlgeräts nach einem der zuvor beschriebenen Art, wobei das Verfahren die Schritte aufweist:
- Gleichrichten und Anheben und/oder Absenken einer ein- oder mehrphasigen Eingangswechselspannung zwischen 110 V und 460 V auf eine konstante Zwischenkreisgleichspannung;
- Zuführen der Zwischenkreisgleichspannung einem Netzteil des Lüfters oder der Lüfter, wobei die Zwischenkreisgleichspannung so bemessen ist, dass über das Netzteil eine Netzteilspannung bereitgestellt werden kann, die für den Betrieb des ersten und/oder zweiten Lüfters erforderlich ist;
- Zuführen der Zwischenkreisgleichspannung dem Drehstromwechselrichter;
- Bestimmen einer geforderten Verdichterleistung; und
- Einregeln einer von dem Drehstromwechselrichter gewandelten verdichterbezogenen Nenndrehspannung bis die geforderte Verdichterleistung erreicht ist.

Einzelheiten der Erfindung werden anhand der in der nachstehenden Figur als Blockdiagramm dargestellten, bevorzugten Ausführungsform erläutert.

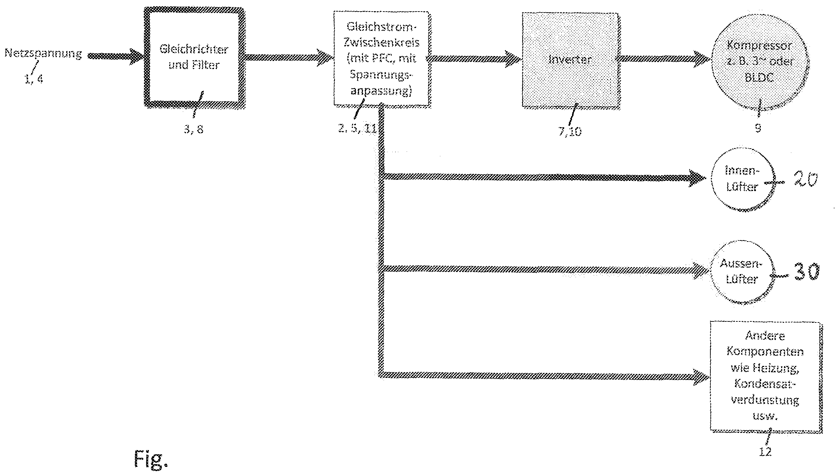

Zur Vereinfachung ist in der Figur lediglich ein Blockschaltbild der Spannungsversorgung 1 des erfindungsgemäßen Kühlgeräts gezeigt. Die Spannungsversorgung 1 weist einen Weitbereichseingang 4 für eine bis zu dreiphasige Wechselspannung oder eine Gleichspannung auf. Es kann weiterhin ein Schutzleiteranschluss bereitgestellt sein. Zur Erhöhung der Störfestigkeit und zur Verminderung von Störaussendungen ist der Weitbereichseingang 4 mit einem Netzfilter 8 verschaltet. Der Netzfilter 8 weist einen dreiphasigen Ausgang auf, der mit einem Eingang eines als Diodenbrücke ausgebildeten Gleichrichters 3 verschaltet ist. Der Gleichrichter 3 erzeugt eine Gleichspannung, mit welcher der Aufwärts- und/oder Abwärtswandler 2 gespeist wird. Der Aufwärts- und/oder Abwärtswandler 2 erzeugt aus der über den Gleichrichter 3 bereitgestellten Gleichspannung eine, je nach Ausgangsspannung, gegenüber dieser Spannung angehobene bzw. abgesenkte, konstante Zwischenkreisgleichspannung von beispielsweise 380 V, mit der ein Kondensator 5 geladen wird. Ein Netzteil für die Lüfter 20, 30 wird von der Zwischenkreisgleichspannung gespeist und ist parallel zu dem Kondensator 5 geschaltet. Bevorzugt ist der Aufwärts- und/oder Abwärtswandler 2 ein kombinierter Aufwärts- und Abwärtswandler.

Der Aufwärts- und/oder Abwärtswandler 2 ist von einem Wandler-Controller 11 gesteuert, wobei der Controller 11 darauf ausgelegt ist, den Aufwärts- und/oder Abwärtswandler 2 in der Art anzusteuern, dass dieser unabhängig von einer an dem Weitbereichseingang 4 anliegenden Spannung den Kondensator 5 mit einer gleichbleibenden elektrischen Spannung auflädt.

Die Zwischenkreisgleichspannung wird in einen Drehstromwechselrichter 7 gespeist, welcher von einem Inverter-Controller 10 angesteuert ist. Der Inverter-Controller 10 ist darauf ausgerichtet, den Drehstromwechselrichter 7 in der Art anzusteuern, dass von dem Drehstromwechselrichter 7 der Drehstrom mit einer Drehstromleistung bereitgestellt wird, die für die Erzielung einer bestimmten Verdichterleistung erforderlich ist. Der von dem Drehstromwechselrichter 7 erzeugte Drehstrom wird über einen Drehstromausgang dem Verdichter 9 bereitgestellt.

Für das Kondensatmanagement kann die Spannungsversorgung 1 weiterhin einen Anschluss 12 für ein Heizelement aufweisen, wobei an dem Anschluss 12 die Kondenstorspannung von beispielsweise 380 V anliegt. Das Heizelement kann für den bedarfsweisen Betrieb über einen Controller (nicht dargestellt) angesteuert werden.

## Patentansprüche

1. Kühlgerät, insbesondere für die Kühlung von in einem Schaltschrank aufgenommenen Komponenten, mit einem ersten Lüfter für die Durchströmung eines ersten Wärmetauschers mit Schaltschrankluft und mit einem zweiten Lüfter für die Durchströmung eines zweiten Wärmetauschers mit Umgebungsluft, wobei das Kühlgerät weiterhin einen verdichtergetriebenen Kühlkreislauf mit einem Verdichter und einem mechanischen oder elektronischen Drosselorgan aufweist, **dadurch gekennzeichnet, dass** das Kühlgerät eine Spannungsversorgung (1) mit einem Aufwärts- und/oder einem Abwärtswandler (2) aufweist, der über einen Gleichrichter (3) mit einem Weitbereichseingang (4) für ein- oder mehrphasige Wechselspannung verbunden ist und einen Kondensator (5) auf eine Zwischenkreisspannung auflädt, die oberhalb oder unterhalb einer an dem Weitbereichseingang (4) anliegenden Netzspannung liegt, wobei der Kondensator (5) parallel zu einem Drehstromwechselrichter (7) geschaltet ist, der einen Drehstrom für den Verdichter bereitstellt, und wobei ein Netzteil (6) mindestens eines der beiden Lüfter parallel zu dem Kondensator (5) geschaltet ist, so dass unabhängig von einer an dem Weitbereichseingang anliegenden ein- oder mehrphasigen Eingangswechselspannung der Verdichter mit einer für eine geforderte Verdichterleistung benötigten Nenndrehspannung betrieben werden kann.

2. Kühlgerät nach Anspruch 1, bei dem die Spannungsversorgung (1) für das Kondensatmanagement einen Heizelementanschluss (12) für ein über einen Controller angesteuertes, elektrisches Heizelement (12) aufweist, wobei der Anschluss (12) parallel zu dem Kondensator (5) geschaltet ist.

3. Kühlgerät nach Anspruch 1, bei dem ein Netzfilter (8) mit mindestens einem Außenleiter, einem Schutzleiter und, falls vorhanden, mit einem Neutralleiter des Weitbereichseingangs (4) verbunden ist, wobei der Schutzleiter von dem Weitbereichseingang (4) durch den Netzfilter (8) und unmittelbar von dort zu einem Drehstromausgang (9), an dem der Drehstrom für den Verdichter bereitgestellt ist, geführt ist.

4. Kühlgerät nach Anspruch 1 oder 3, bei dem der Drehstromwechselrichter (7) von einem Invertercontroller (10) derart angesteuert ist, dass von dem Drehstromwechselrichter (7) der Drehstrom mit einer Drehstromleistung bereitgestellt ist, die für die Erzielung einer bestimmten Verdichterleistung erforderlich ist.

5. Kühlgerät nach einem der vorangegangen Ansprüche, bei dem der Aufwärts- und/oder Abwärtswandler (2) derart über einen Wandlercontroller (11) angesteuert ist, dass der Kondensator (5) über den Aufwärts- und/oder Abwärtswandler (2) auf eine Zwischenkreisspannung aufgeladen wird, die derart bemessen ist, dass über das Netzteil (6) eine Netzteilspannung für den Betrieb des ersten und/oder zweiten Lüfters bereitgestellt ist.

6. Kühlgerät nach einem der vorangegangen Ansprüche, bei dem der Weitbereichseingang (4) für ein- oder dreiphasige Wechselspannung mindestens für Eingangsspannungen zwischen 110 V und 240 V und/oder zwischen 380 V und 460 V ausgelegt ist.

7. Kühlgerät nach einem der vorangegangen Ansprüche, bei dem der Verdichter und/oder die Lüfter BLDC-Motoren aufweisen.

8. Verwendung eines Kühlgeräts nach einem der vorangegangenen Ansprüche, um unabhängig von einer an dem Weitbereichseingang (4) anliegenden ein- oder mehrphasigen Eingangswechselspannung den Verdichter mit einer für eine geforderte Verdichterleistung benötigte Nenndrehspannung zu betreiben, wobei zur Leistungsvariation des Verdichters der Drehstromwechselrichter (7) darauf ausgelegt ist, eine Nenndrehspannung in Abhängigkeit der geforderten Verdichterleistung anzuheben oder abzusenken.

9. Verfahren für den Betrieb eines Kühlgeräts nach einem der Ansprüche 1 bis 7, das die Schritte aufweist:
- Gleichrichten und Anheben und/oder Absenken einer ein- oder mehrphasigen Eingangswechselspannung zwischen 110 und 460 V auf eine konstante Zwischenkreisgleichspannung;
- Zuführen der Zwischenkreisgleichspannung einem Netzteil (6) des Lüfters oder der Lüfter, wobei die Zwischenkreisspannung so bemessen ist, dass über das Netzteil eine Netzteilspannung bereitgestellt werden kann, die für den Betrieb des ersten und/oder zweiten Lüfters erforderlich ist;
- Zuführen der Zwischenkreisgleichspannung dem Drehstromwechselrichter (7);
- Bestimmen einer geforderten Verdichterleistung; und
- Einregeln einer von dem Drehstromwechselrichter (7) gewandelten verdichterbezogenen Nenndrehspannung bis die geforderte Verdichterleistung erreicht ist.

## Claims

1. A cooling device, in particular for cooling components that are housed in a switchgear cabinet, comprising a first cooling fan for blowing air from the switchgear cabinet through a first heat exchanger, and a second cooling fan for blowing ambient air through a second heat exchanger, the cooling device further comprising a compressor-driven cooling circuit having a compressor and a mechanical or electronic choking element, **characterized in that** the cooling device comprises a voltage supply (1) having a step-up and/or a step-down converter (2), which is connected via a rectifier (3) to a wide-range input (4) for single-phase or multiphase AC voltage, and which charges a capacitor (5) to a DC link voltage which is higher or lower than a mains voltage across the wide-range input (4), the capacitor (5) being connected in parallel to a three-phase inverter (7) which supplies three-phase current to the compressor, and a power supply unit (6) of at least one of the two cooling fans being connected in parallel to the capacitor (5), so that, irrespective of a single-phase or multiphase input AC voltage across the wide-range input, the compressor can be operated on the nominal three-phase voltage that is necessary for a required compressor output level.

2. The cooling device according to claim 1, wherein for condensate management, the voltage supply (1) has a heating element terminal (12) for connecting an electric heating element (12) that is controlled by a controller, said terminal (12) being connected in parallel to the capacitor (5).

3. The cooling device according to claim 1, wherein a mains filter (8) is connected to at least one outer conductor, one grounding conductor and, if present, one neutral conductor of the wide-range input (4), the grounding conductor leading from the wide-range input (4) through the mains filter (8) and from there directly to a three-phase outlet (9), to which the three-phase current for the compressor is supplied.

4. The cooling device according to claim 1 or 3, wherein the three-phase inverter (7) is controlled by an inverter controller (10) such that the three-phase current is supplied by the three-phase inverter (7) at the three-phase power required to achieve a given compressor output level.

5. The cooling device according to any of the preceding claims, wherein the step-up and/or step-down converter (2) is controlled via a converter controller (11) such that the capacitor (5) is charged via the step-up and/or step-down converter (2) to a DC link voltage, the dimensions of which are such that the power supply voltage required to operate the first and/or second cooling fan is supplied via the power supply unit (6).

6. The cooling device according to any of the preceding claims, wherein the wide-range input (4) for single-phase or three-phase AC voltage is designed at least for input voltages of between 110 V and 240 V and/or between 380 and 460V.

7. The cooling device according to any of the preceding claims, wherein the compressor and/or the cooling fans have BLDC motors.

8. A use of a cooling device according to any of the preceding claims for operating the compressor on the nominal three-phase voltage necessary for a required compressor output level, irrespective of a single-phase or multiphase input AC voltage across the wide-range input (4), wherein for varying the output level of the compressor, the three-phase inverter (7) is designed to raise or lower a nominal three-phase voltage based on the compressor output level that is required.

9. A method for operating a cooling device according to any of claims 1 to 7, comprising the following steps:
- rectifying and raising and/or lowering a single-phase or multiphase input AC voltage between 110 V and 460 V to a constant DC link voltage;
- supplying the DC link voltage to a power supply unit (6) of the cooling fan or cooling fans, the dimensions of the DC link voltage being such that the power supply unit is able to supply the power supply voltage required to operate the first and/or second cooling fan;
- feeding the DC link voltage to the three-phase inverter (7);
- determining the required compressor output level;
- adjusting the compressor-based nominal three-phase voltage that has been converted by the three-phase inverter (7) until the required compressor output level is achieved.

## Revendications

1. Appareil de refroidissement, plus particulièrement pour le refroidissement de composants logés dans une armoire de commande, avec un premier ventilateur pour la traversée d'un premier échangeur thermique avec l'air de l'armoire de commande et avec un deuxième ventilateur pour la traversée d'un deuxième échangeur thermique avec de l'air ambiant, l'appareil de refroidissement comprenant en outre un circuit de refroidissement actionné par un compresseur, avec un compresseur et un organe d'étranglement mécanique ou électronique, **caractérisé en ce que** l'appareil de refroidissement comprend une alimentation en tension (1) avec un convertisseur vers le haut et/ou vers le bas (2), qui est relié par l'intermédiaire d'un redresseur (3) avec une entrée à large plage (4) pour une tension alternative monophasée ou multiphasée et charge un condensateur (5) à une tension de circuit intermédiaire, qui se trouve au-dessus ou en dessous d'une tension de réseau appliquée à l'entrée à large plage (4), le condensateur (5) étant branché parallèlement à un onduleur triphasé (7), qui génère un courant triphasé pour le compresseur, et un transformateur (6) d'au moins un des deux ventilateurs étant branché parallèlement au condensateur (5) de façon à ce que, quelle que soit la tension alternative d'entrée monophasée ou multiphasée appliquée à l'entrée à large plage, le compresseur puisse être actionné avec une tension triphasée nécessaire pour une puissance requise du compresseur.

2. Appareil de refroidissement selon la revendication 1, dans lequel l'alimentation en tension (1) pour la gestion du condensat comprend un raccord d'élément chauffant (12) pour un élément chauffant électrique (12) contrôlé par l'intermédiaire d'un contrôleur, le raccord (12) étant branché parallèlement au condensateur (5).

3. Appareil de refroidissement selon la revendication 1, dans lequel un filtre de réseau (8) est relié avec au moins un conducteur externe, un conducteur de protection et, le cas échéant, avec un conducteur neutre de l'entrée à large plage (4), le conducteur de protection étant guidé de l'entrée à large plage (4) à travers le filtre de réseau (8) et directement de là vers une sortie de courant triphasé (9), au niveau de laquelle le courant triphasé est mis à la disposition du compresseur.

4. Appareil de refroidissement selon la revendication 1 ou 3, dans lequel l'onduleur triphasé (7) est commandé par un contrôleur inverseur (10) de façon à ce que, à partir de l'onduleur triphasé (7) le courant triphasé est mis à disposition avec une puissance de courant triphasé qui est nécessaire pour l'obtention d'une puissance de compresseur déterminée.

5. Appareil de refroidissement selon l'une des revendications précédentes, dans lequel le convertisseur vers le haut et/ou vers le bas (2) est commandé par l'intermédiaire d'un contrôleur convertisseur (11) de façon à ce que le condensateur (5) soit chargé par le convertisseur vers le haut et/ou vers le bas (2) à une tension de circuit intermédiaire qui est telle que le transformateur (6) puisse mettre à disposition une tension de transformateur pour l'actionnement du premier et/ou du deuxième ventilateur.

6. Appareil de refroidissement selon l'une des revendications précédentes, dans lequel l'entrée à large plage (4) est conçue pour une tension alternative monophasée ou triphasée au moins pour des tensions d'entrée entre 110 V et 240 V et/ou entre 380 V et 460 V.

7. Appareil de refroidissement selon l'une des revendications précédentes, dans lequel le compresseur et/ou les ventilateurs comprennent des moteurs BLDC.

8. Utilisation d'un appareil de refroidissement selon l'une des revendications précédentes, afin d'actionner, quelle que soit une tension alternative d'entrée monophasée ou multiphasée appliquée à l'entrée à large plage (4), le compresseur avec une tension triphasée nominale nécessaire pour la puissance requise du compresseur, l'onduleur triphasé (7) étant conçu, afin de faire varier la puissance du compresseur, pour augmenter ou diminuer une tension triphasée nominale en fonction de la puissance requise du compresseur.

9. Procédé pour l'actionnement d'un appareil de refroidissement selon l'une des revendications 1 à 7, qui comprend les étapes suivantes :
- redressement et augmentation et/ou diminution d'une tension alternative d'entrée monophasée ou multiphasée entre 110 V et 460 V à une tension continue de circuit intermédiaire ;
- application de la tension continue de circuit intermédiaire dans un transformateur (6) du ventilateur ou des ventilateurs, la tension de circuit intermédiaire étant telle que le transformateur puisse mettre à disposition une tension de transformateur qui est nécessaire pour l'actionnement du premier et/ou du deuxième ventilateur ;
- application de la tension continue de circuit intermédiaire à l'onduleur triphasé (7) ;
- détermination d'une puissance requise du compresseur ; et
- régulation d'une tension triphasée nominale spécifique au compresseur, convertie par l'onduleur triphasé (7), jusqu'à ce que la puissance requise du compresseur soit atteinte.
